(19) Europäisches Patentamt / European Patent Office / Office européen des brevets

(11) **EP 2 319 180 B1**

(12) **FASCICULE DE BREVET EUROPEEN**

(45) Date de publication et mention
de la délivrance du brevet:
**25.01.2012   Bulletin 2012/04**

(51) Int Cl.:
*H03L 1/00* (2006.01)         *H03L 7/00* (2006.01)
*H04B 1/00* (2006.01)

(21) Numéro de dépôt: **09781512.0**

(22) Date de dépôt: **05.08.2009**

(86) Numéro de dépôt international:
**PCT/EP2009/060148**

(87) Numéro de publication internationale:
**WO 2010/018111 (18.02.2010 Gazette 2010/07)**

(54) **OSCILLATEUR A QUARTZ A PRECISION ELEVEE ET DE FAIBLE CONSOMMATION**

HOCHPRÄZISER UND VERBRAUCHSARMER QUARZOSZILLATOR

HIGH-PRECISION AND LOW-CONSUMPTION QUARTZ OSCILLATOR

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **14.08.2008   FR 0804604**

(43) Date de publication de la demande:
**11.05.2011   Bulletin 2011/19**

(73) Titulaire: **THALES**
**92200 Neuilly-sur-Seine (FR)**

(72) Inventeur: **SIMONDIN, Jean-Pierre**
**F-49300 Cholet (FR)**

(74) Mandataire: **Dudouit, Isabelle**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 1 585 223     US-A1- 2003 095 008**

**Description**

L'objet de l'invention concerne un oscillateur à quartz faible consommation capable de fournir un signal stable dans le temps à partir d'un oscillateur numérique basse puissance et d'un oscillateur à quartz compensé en température de type TCXO corrigé en température et présentant une consommation plus élevée. Elle est notamment utilisée pour la conservation de l'heure dans des équipements en fonctionnement, en veille ou l'arrêt, dans des contextes où la source d'alimentation est faible, par exemple, pour des piles de faible puissance.

La conservation de l'heure dans les équipements de radio communications numériques autonomes est assurée habituellement par un oscillateur à quartz dont la sortie, généralement après un diviseur, incrémente régulièrement un compteur. L'heure peut être déduite de ce compteur. La précision de l'heure fournie doit respecter des critères liés, en particulier, au débit des communications radio et au temps d'inactivité entre ces communications. D'autre part, les impulsions produites par l'oscillateur après division peuvent servir à piloter des séquenceurs gérant l'état de l'équipement radio, en particulier à l'arrêt de l'équipement ou lorsque ce dernier est en veille, ou encore provoquer des interruptions de processeurs. Ces impulsions doivent respecter des contraintes de gigue de phase, plus connue sous le terme de « jitter ».

La réalisation d'un tel dispositif suppose de trouver le compromis le plus satisfaisant entre plusieurs objectifs contradictoires, à savoir :

- Les coûts d'étude et de fabrication aussi réduits que possible,
- Le fonctionnement sous une tension réduite qui doit respecter une faible consommation pour permettre la conservation de l'heure sur une source d'énergie intégrée (pile ou accumulateur) sur une durée qui peut dépasser un an dans certains cas,
- Le maintien d'une précision du temps à court, moyen et parfois long terme, suffisante pour le maintien des fonctionnalités opérationnelles de l'équipement, notamment sa capacité à communiquer après un temps d'inactivité. Cette dernière contrainte doit prendre en compte la variation des conditions de fonctionnement du dispositif : tension d'alimentation qui décroît dans le temps, température qui peut varier entre des limites définies, vitesse de variation de cette température.

Une première solution proposée par l'art antérieur concerne la réalisation d'une horloge précise et de faible consommation basée sur l'emploi d'un oscillateur à quartz de fréquence modérée, inférieure à 10 MHz, fonctionnant à faible puissance, suivi d'un diviseur. Les variations relativement élevées d'un tel oscillateur en fonction de la température sont compensées par une calibration par apprentissage avec un nombre suffisant de températures et un stockage de paramètres dans une mémoire non volatile. La correction est assurée par un circuit processeur périodiquement mis en service pour lire la mémoire non volatile, pour générer une tension analogique qui est appliquée sur une diode varicap qui ajuste alors la fréquence de l'oscillateur en fonction de la valeur mémorisée. Les variations de l'oscillateur en fonction de la température sont suffisamment faibles pour qu'un rythme de correction assez lent (par exemple toutes les 10 secondes) soit suffisant pour tolérer des variations assez rapides de température, par exemple 3˚C/mn. La conception d'un tel oscillateur est délicate et le coût de réalisation élevé. D'autre part, la consommation reste encore relativement importante à cause de la fréquence du quartz élevée et descend difficilement en dessous de 400 microampères. L'un des inconvénients de cet art antérieur est qu'il fait appel à un oscillateur à quartz fonctionnant à faible puissance, et demande une conception spécifique, délicate et coûteuse, avec une consommation relativement élevée.

Afin de réduire la consommation, une solution consiste à réduire la fréquence de l'oscillateur à une valeur correspondant à celle utilisée généralement dans les montres, c'est-à-dire 32768 KHz. La stabilité propre de l'oscillateur est alors nettement moins bonne et sa compensation par calibration en fonction de la température est plus difficile. On n'atteint généralement pas la précision souhaitée, par exemple de 2ppm dans une large gamme de température pouvant varier entre - 40 ˚C et +85 ˚C.

Une autre solution consiste à employer 2 oscillateurs :

- Un oscillateur à fréquence élevée, de plus de 10MHz, de grande précision, compensé en température, de vieillissement limité, mais de consommation relativement élevée ; un tel composant est connu sous l'abréviation anglo-saxonne de TCXO (Temperature Compensated Crystal Oscillator) ; son coût est relativement bas. Cet oscillateur est l'horloge principale de l'équipement et il est utilisé en fonctionnement pour cadencer les processeurs ; Il n'est pas alimenté lorsque l'équipement est en veille ou à l'arrêt.
- Un oscillateur à basse fréquence, généralement de l'ordre de 32768 KHz, peu précis, non compensé en température, de vieillissement plus élevé, mais de très faible consommation et de faible coût ; cet oscillateur est maintenu en fonctionnement en veille et parfois à l'arrêt.

Les inconvénients engendrés par l'utilisation de l'oscillateur basse fréquence sont en général compensés par l'une ou plusieurs des solutions suivantes :

- La calibration de l'oscillateur basse fréquence en usine en fonction de la température et le stockage de l'erreur dans une mémoire non volatile (erreur mesurée au cours du calibrage); l'application périodique de la correction en veille ou à l'arrêt,
- La calibration automatique de l'oscillateur basse fréquence par rapport à l'oscillateur haute fréquence lorsque l'équipement est en fonctionnement et le stockage de l'erreur dans une mémoire non volatile,
- La calibration automatique de l'oscillateur basse fréquence lors de communications avec une station de base et le stockage de l'erreur dans une mémoire non volatile,
- La prise en compte de paramètres typiques de l'oscillateur basse fréquence : le vieillissement probable, la variation en fonction de la tension d'alimentation.

Dans le cas d'utilisation de deux oscillateurs, la solution n'est en général pas conçue pour une génération d'une horloge permanente compensée de précision, indépendante du reste de l'équipement. Dans le cas où l'horloge est physiquement générée, la commutation entre les deux oscillateurs produit une incertitude sur sa phase, incertitude qui peut être incompatible de la précision temporelle souhaitée et de la gigue spécifiée. C'est le cas de la demande de brevet EP 1 585 223 qui décrit une méthod et un circuit pour déterminer un facteur de calibration entre un signal d'horloge rapide et de précision élevée, et un signal d'horloge plus lent. Cette invention propose d'appliquer le signal d'horloge plus lent (-20 à 100KHz) à un diviseur à rang variable, lequel rang est stable et est ajusté périodiquement même à l'arrêt, après un comptage du signal d'horloge rapide pendant une période du signal d'horloge plus lent. Ce procédé ne permet pas d'atteindre une précision importante à cause du faible temps de comptage et de la variation importante de fréquence entre chaque rang de division. Il est évoqué une précision meilleure que 5%, au lieu de l'objectif de 2ppm ou 0.0002% indiqué précédemment pour la présente invention.

Les solutions proposées par l'art antérieur se révèlent donc soit trop coûteuses, soit trop consommatrices pour un système fonctionnant sur pile, ou ayant une faible autonomie de puissance ou d'énergie, soit insuffisamment précises en fréquence ou phase.

L'objet de la présente invention consiste notamment à remédier au moins aux problèmes précités et repose sur l'utilisation d'un oscillateur basse fréquence A présentant comme particularité de peu consommer en permanence, dont la fréquence FA est choisie comme étant un multiple de la fréquence du signal désiré, ledit oscillateur est couplé à un oscillateur à quartz compensé en température dont la fréquence est de l'ordre de 10 à 30 MHz, qui présente une stabilité élevée. Tout autre dispositif présentant des caractéristiques comparables à celles d'un oscillateur à quartz compensé en température qui présente une stabilité élevée.

L'oscillateur compensé en température TCXO est mis périodiquement sous tension pour mesurer l'erreur de l'oscillateur basse fréquence A. Un circuit logique de correction selon l'invention permet notamment de compenser numériquement l'erreur par un diviseur à rang variable et d'anticiper numériquement les variations régulières de fréquence. Ceci permet d'obtenir le maintien d'une horloge stable en veille ou à l'arrêt

L'invention concerne un oscillateur basse fréquence de précision et de faible consommation caractérisé en ce qu'il comporte en combinaison au moins les éléments suivants :

- Un oscillateur basse fréquence A de faible consommation, fonctionnant à une fréquence $F_A$, et émettant un signal $S_A$
- Un oscillateur à quartz compensé en température TCXO B utilisé comme référence fréquentielle, fonctionnant à une fréquence $F_B$,
- Un circuit numérique adapté à fournir une fréquence Fcor stable comprenant au moins :

  o Une entrée recevant un signal d'alimentation,
  o Une entrée recevant en permanence un signal SA issu de l'oscillateur A,
  o Une entrée recevant le signal $S_B$ issu de l'oscillateur B pendant la calibration, réalisée à un rythme $R_1$, lorsqu'un commutateur est activé par un séquenceur gérant l'ensemble des composants formant le circuit,
  o Un compteur comptant le nombre d'impulsions émises par l'oscillateur TCXO B pendant une période donnée, de façon à représenter l'erreur entre les oscillateurs A et B
  o Une mémoire mémorisant le nombre $N_B$ issu du compteur ainsi que des nombres $N_{B-1}$, $N_{B-2}$, $N_{B-3}$,... $N_{B-n}$ d'impulsions émises par l'oscillateur B et comptées par le compteur pendant des périodes précédentes,
  o Un module de calcul de correction adapté à analyser les résultats du comptage $N_B$ à un moment donné et ceux des comptages $N_{B-n}$ précédemment enregistrés, et d'en déduire une correction à appliquer au comptage $N_B$
  o Un additionneur recevant les valeurs issues du compteur et du module de calcul de correction, et dont la sortie délivre un nombre représentant une erreur corrigée E qui est mémorisée,
  o Un accumulateur, dans lequel on additionne ladite erreur corrigée à un rythme $R_2$, comprenant une valeur seuil prédéfinie M, lorsque la valeur de l'accumulateur prise en valeur absolue, dépasse la valeur seuil prédéfinie M, ledit accumulateur délivre à un diviseur de rang variable, d'une part un indicateur de dépassement et d'autre part, le signe de ce dépassement ; dans le cas de dépassement, on soustrait de, ou on ajoute à l'accumulateur ladite valeur seuil prédéfinie M pour annuler le dépassement,

o Un diviseur de rang variable ayant une valeur nominale K, en cas de dépassement de la valeur de l'accumulateur, le rang de division K est modifié en K+1 ou K-1 selon le signe de la valeur de l'erreur contenue dans ledit accumulateur, pendant une période du signal de sortie Scorr, ledit diviseur

à rang variable produisant le signal souhaité et corrigé Scorr. L'oscillateur A est, par exemple, un oscillateur fonctionnant à une fréquence $F_A$ dont la valeur est choisie de façon telle que ledit oscillateur ait une faible consommation, une précision et une stabilité en température maîtrisées. Cette valeur de fréquence est, par exemple, sensiblement égale à 32768 Hz.

L'oscillateur TCXO B est un oscillateur fonctionnant à une fréquence $F_B$ choisie afin que ledit oscillateur présente une faible consommation, un faible encombrement et un faible prix de revient, telle qu'une valeur de fréquence comprise dans l'intervalle compris entre 10 et 30MHz.

Le circuit peut être un composant fabriqué en technologie CMOS ou tout autre technologie à faible consommation sous forme d'un ASIC, d'un CPLD, d'un FPGA ou de microprocesseur.

L'oscillateur peut être alimenté par un régulateur disposé sur la tension d'alimentation et un circuit composé d'une résistance R et d'une capacité réservoir C situé entre l'alimentation et le régulateur.

L'oscillateur selon l'invention est notamment utilisé dans le domaine des radiocommunications.

L'invention concerne aussi un procédé pour délivrer un signal Scorr de fréquence stable dans le temps à partir d'un oscillateur basse fréquence de précision et de faible consommation A, émettant à une fréquence FA un signal SA caractérisé en ce qu'il comporte en combinaison au moins les étapes suivantes :

d éterminer un premier rythme $R_1$ fixe pour mesurer périodiquement l'erreur de fréquence de l'oscillateur A :

E tape 1a : mettre sous tension un oscillateur à quartz compensé en température TCXO B et attendre sa stabilisation,

E tape 2a : compter dans un compteur des périodes ou transitions du signal $S_B$, émis par l'oscillateur B (nombre d'impulsions émises) pendant une durée T (durée de comptage) définie à partir de la période du signal $S_A$,

E tape 3a : mettre hors tension l'oscillateur à quartz compensé en température TCXO B, mémoriser le nombre $N_B$ correspondant au comptage de l'étape 2a, et mettre à jour les nombres $N_{B-1}$, $N_{B-2}$, $N_{B-3}$,... $N_{B-n}$ d'impulsions émises pas l'oscillateur B pendant les periodes précédentes et comptées par le compteur prendant des périodes précédentes,

E tape 4a: comparer le résultat du comptage $N_B$ obtenu pendant la durée T à celui des mesures précédentes $N_{B-1}$, $N_{B-2}$, $N_{B-3}$,... $N_{B-n}$, déterminer une loi de variation polynomiale afin d'estimer la correction à appliquer à $N_B$, pour obtenir finalement une erreur moyenne E probable pour la prochaine période du rythme $R_1$ et mémoriser cette valeur E,

Déterminer un deuxième rythme $R_2$ et exécuter les étapes suivantes :

E tape 1b : ajouter l'erreur moyenne mémorisée E à un accumulateur au rythme $R_2$,

E tape 2b : Lorsque la valeur de l'accumulateur, prise en valeur absolue, dépasse la valeur seuil prédéfinie M, alors transmettre à un diviseur de rang variable ayant une valeur nominale K, d'une part un indicateur de dépassement, et d'autre part, le signe de ce dépassement et exécuter les opérations suivantes :

- Modifier le rang de division K en K+1 ou K-1 selon le signe de la valeur de l'erreur contenue dans l'accumulateur, pendant une période du signal de sortie Scorr
- Soustraire de, ou ajouter à, l'accumulateur la valeur seuil M pour annuler le dépassement.

Selon un mode de réalisation, le rythme $R_2$ est déterminé à partir de l'erreur maximale admissible égale en valeur absolue à la valeur seuil de l'accumulateur M et de l'amplitude de la correction temporelle appliquée à chaque dépassement de l'accumulateur.

D'autres caractéristiques et avantages du dispositif selon l'invention apparaîtront mieux à la lecture de la description qui suit d'un exemple de réalisation donné à titre illustratif et nullement limitatif annexé des figures qui représentent :

• La figure 1, un exemple d'architecture selon l'invention comportant les deux oscillateurs précités et le circuit numérique de compensation d'erreur.
- La figure 2, un diagramme du fonctionnement général de l'architecture de la figure 1, et
- La figure 3, les étapes mises en oeuvre pour mesurer l'erreur de fréquence.

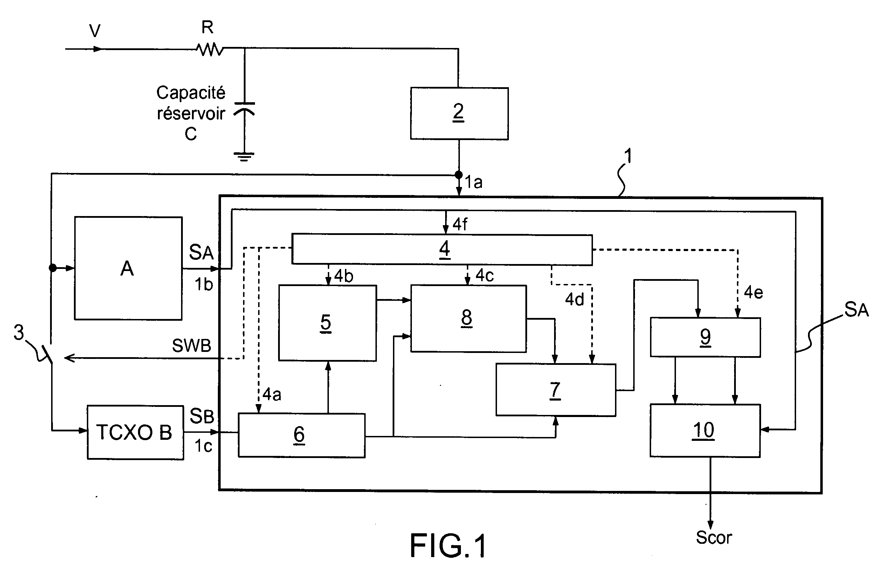

La figure 1 représente un exemple d'architecture d'un oscillateur basse fréquence de précision et de faible consommation selon l'invention. Dans le but de mieux faire comprendre, l'objet de la présente invention, l'exemple est donné pour une fréquence de sortie de l'oscillateur basse fréquence typiquement comprise entre 1024 Hz et quelques Hz, et sa stabilité requise de l'ordre de 2 ppm sur un an dans la gamme de température -40 à 85˚C et en présence de variations maximales de température d'environ 3˚C par mn. La consommation requise peut être de l'ordre de 100$\mu$A avec des appels de courant inférieurs à 1 mA.

Une alimentation symbolisée par la lettre V vient alimenter un circuit numérique 1 et aussi un premier oscillateur à quartz A basse fréquence et un oscillateur de type TCXO B.

La fréquence de l'oscillateur A est typiquement de l'ordre de 32768 Hz, fréquence utilisée en horlogerie et dans les circuits de conservation de l'heure des équipements électroniques (Real Time Clock). L'oscillateur A est la source du signal de sortie désirée, par division. Ce signal ne sera jamais commuté sur l'oscillateur TCXO B, afin de préserver une phase continue lors des passages des modes veille ou arrêt ou mode de fonctionnement normal. L'oscillateur B est alimenté pendant une courte période, à un rythme régulier. L'oscillateur B TCXO fonctionne à une fréquence typiquement comprise, par exemple, entre 10 et 30 MHz. Sa mise en route et celle des circuits associés (décrits ci-après) conduisent à une consommation non négligeable de l'ordre de plusieurs mA. L'obtention d'une consommation moyenne faible, typiquement de 100 $\mu$A suppose une mise en service du TCXO pendant une faible partie du temps. Par exemple, pour une calibration de l'oscillateur A à 0.1 ppm, le temps de mise en service du TCXO sera de 0.5 secondes environ, ce qui conduit à une période de mise en service de l'ordre d'une minute. Pendant cet intervalle relativement important, la température peut varier sensiblement et modifier la fréquence de l'oscillateur A. Les oscillateurs à 32768 Hz ont généralement une précision médiocre, (par exemple de +/-20ppm à température ambiante) et surtout de fortes variations en fonction de la température (variation parabolique atteignant -160 ppm à -40˚C et +90˚C qui se traduisent par une pente de 4.5 ppm/˚C. Pour un objectif de résistance aux variations de température de 3˚C/mn, il est ainsi possible d'atteindre une variation de fréquence FA de l'oscillateur A de 13.5 ppm/mn avec un oscillateur standard à 32768 Hz à la température de - 40˚C. Ceci conduit à la nécessité de compenser de manière prédictive les variations de fréquence, grâce à la prise en compte des mesures précédentes de l'erreur.

Pour le TCXO B, on utilisera une fréquence la plus basse possible pour limiter la consommation, mais permettant de respecter un faible coût et d'obtenir une bonne stabilité de l'oscillateur. L'ensemble des circuits est alimenté sous faible tension, par exemple 2,5V, par l'intermédiaire d'un régulateur linéaire 2 à faible chute de tension afin de garantir la stabilité maximale du TCXO.

Une architecture permettant d'obtenir les performances énoncées ci-dessus est décrite à la figure 1. Les deux oscillateurs A et TCXO B sont reliés à un circuit numérique ou processeur 1. Le processeur a notamment pour fonction :

- De déclencher régulièrement des opérations de mise en service du TCXO B, et de mesure de l'oscillateur A par rapport au TCXO B, par comptage de périodes ou d'impulsions,
- De traiter le résultat de mesure (stockage, calcul de l'erreur probable),
- D'appliquer des corrections régulières de l'horloge en fonction de cette erreur.

Le processeur a une première entrée 1 a qui reçoit l'alimentation après passage dans un régulateur 2. Une deuxième entrée 1 b reçoit le signal SA issu de l'oscillateur A à une fréquence $F_A$. Une troisième entrée 1 c reçoit le signal $S_B$ issu de l'oscillateur TCXO à une fréquence $F_B$. L'oscillateur B est alimenté périodiquement grâce à un interrupteur 3 actionné par une ligne reliée à un séquenceur 4. Le séquenceur 4 a notamment pour fonction de gérer les différentes étapes mises en oeuvre et de commander les différents composants du processeur 1 ainsi que les deux oscillateurs A et B. Les sorties du séquenceur sont un signal 4a autorisation du comptage dans le compteur 6, 4b enregistrement dans une zone mémoire 5, 4c commande vers un bloc de calcul 8, 4d calcul et mémorisation de l'erreur E dans un additionneur, 4e vers un accumulateur 9. Le séquenceur a aussi une sortie pour le signal SWB actionnant l'interrupteur 3. Il reçoit en entrée 4f le signal $S_A$ issu de l'oscillateur A.

La sortie du compteur 6 correspond à l'erreur mesurée avant correction. Une zone mémoire 5 enregistre les dernières valeurs de l'erreur calculées à partir du comptage $N_B$ du signal $S_B$ réalisé dans le compteur 6 à savoir le nombre $N_B$ issu du compteur ainsi que les nombres $N_{B-1}$, $N_{B-2}$, $N_{B-3}$,... $N_{B-n}$ mesurés précédemment..

A partir de ces valeurs mémorisées, le bloc de calcul 8 détermine la loi suivie par l'erreur en fonction du temps, et en déduit la correction probable à appliquer à la dernière mesure de l'erreur (prévision de la variation moyenne de l'erreur), de façon à compenser en moyenne les variations de fréquence (donc de température) dans la période suivante entre 2 opérations de mesure de l'oscillateur A par rapport au TCXO B.

Cette correction est ajoutée à la dernière mesure de l'erreur dans l'additionneur 7. En sortie de l'additionneur la valeur obtenue correspond à l'erreur corrigée. La sortie de l'additionneur 7 est mémorisée et est ajoutée à un accumulateur 9 à un rythme $R_2$ défini par le séquenceur 4. Lorsque la valeur de l'accumulateur 9 dépasse une valeur seuil M prédéfinie, alors ce dernier délivre à un diviseur de rang variable 10, ayant une valeur nominale K d'une part un indicateur de dépassement et d'autre part le signe de ce dépassement. Le diviseur à rang variable produit le signal souhaité et corrigé Scor. La valeur seuil M est soustraite de, ou ajoutée à, l'accumulateur, selon le signe du dépassement.

Le processeur ou circuit numérique 1 est un circuit processeur numérique de faible consommation statique et dynamique, qui pourra être basé, par exemple, sur la technologie semiconducteur CMOS (abrégé anglo-saxon de Complementary Metal Oxide Semiconductor) ou toute autre technologie à faible consommation, sous forme d'un ASIC (Application Specific Integrated Circuit), d'un circuit intégré programmable CPLD (Complex Programmable Logic Device), d'un microprocesseur ou tout autre dispositif équivalent.

Sur la figure 1 sont aussi représentés une capacité réservoir C et une résistance série R associée, reliées au régulateur linéaire 2. Leurs paramètres physiques sont choisis notamment pour assurer :

- Une chute de tension crête compatible de la tension d'alimentation disponible et de la tension d'alimentation des composants,
- Un coût, un encombrement, des variations dans la gamme climatique et une consommation résiduelle la plus faible possible.

Un tel agencement permet de fournir les appels de courants nécessaires pendant la mise en service du TCXO et de limiter le courant prélevé sur la source d'énergie, par exemple, une pile au Lithium au travers de la résistance série R. La pile dans ce cas est connectée indirectement au niveau de V sur la figure 1. Dans certains cas d'applications, d'autres circuits électroniques peuvent se trouver entre la pile et V.

Après avoir décrit un exemple d'architecture à la figure 1, les figures 2 et 3 vont permettre de suivre le déroulement fonctionnement d'un tel système et la mesure de l'erreur de fréquence. En l'absence de correction, le signal fourni par le processeur 1 correspond au signal de l'oscillateur A à une fréquence $F_A$ divisé par le diviseur à rang variable 10 qui a réglé son facteur de division à la valeur nominale K.

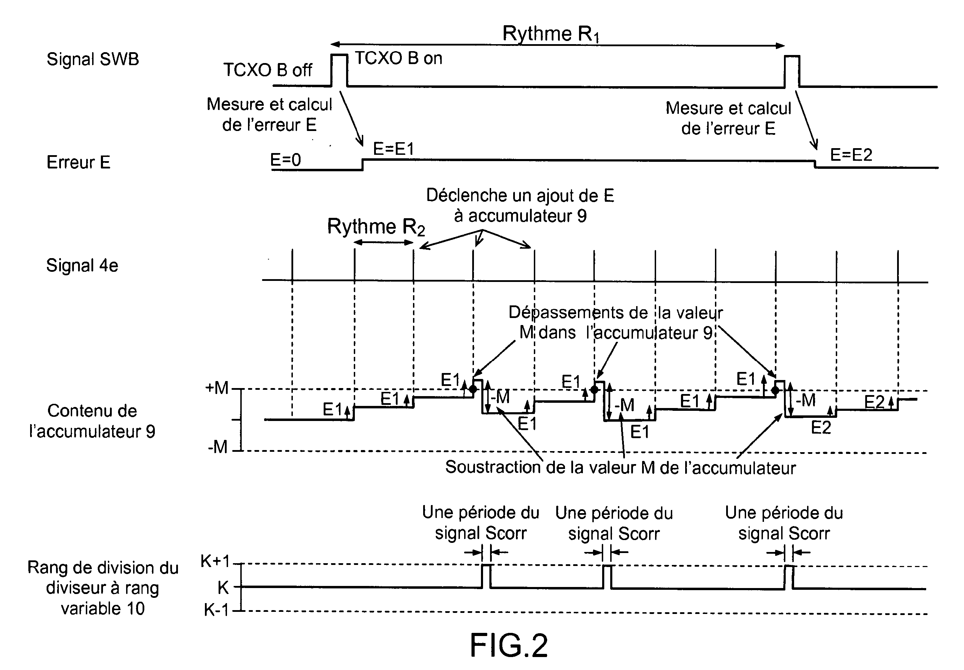

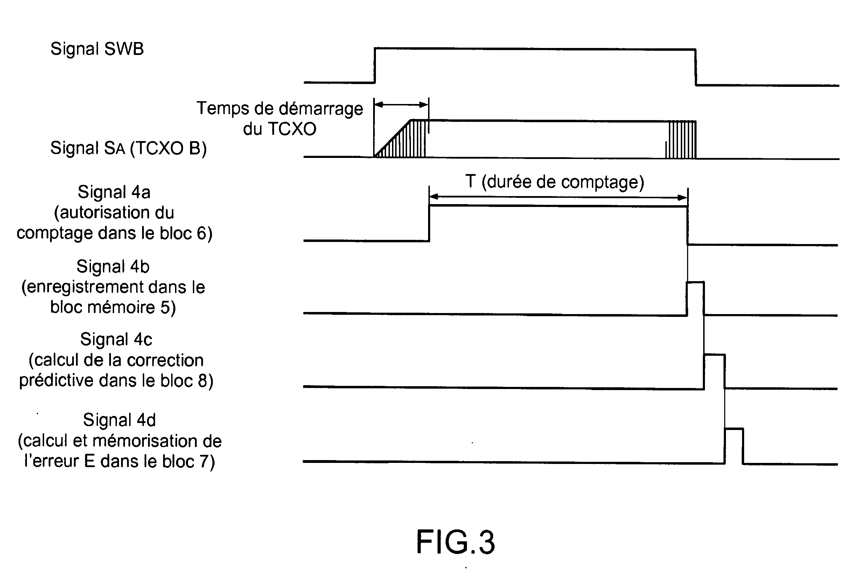

La figure 2 schématise un « chronogramme » dans l'enchaînement des séquences du fonctionnement de l'oscillateur selon l'invention et la figure 3 un chronogramme des signaux pour la mesure de l'erreur.

Le séquenceur 4 détermine un premier rythme $R_1$ fixe dépendant de la dérive potentielle de l'oscillateur A en température, de la vitesse de variation de cette température, et de la qualité de la compensation décrite ci-après. La mesure et le calcul de l'erreur vont s'effectuer à ce rythme. Pour cela, le processeur via le séquenceur 4 va alors exécuter les opérations suivantes :

Etape 1a : la mise sous tension de l'oscillateur TCXO B et attente de la stabilisation de son fonctionnement. Le temps de stabilisation est donné par le constructeur du TCXO B. Le temps de stabilisation est par exemple de l'ordre de 10 ms ;

Etape 2a : compter des périodes ou transitions du signal $S_B$, (nombre d'impulsions émises) pendant une durée T (durée de comptage) définie à partir de la période du signal SA, (signal 4a autorisation du comptage dans le bloc 6). Un nombre suffisant d'évènements doit être compté pour assurer la précision voulue ; par exemple si une précision de $0.5\ 10^{-7}$ est demandée, alors il faut compter $1/0.5\ 10^{-7} = 2\ 10^7$ évènements ; si chaque évènement est une période du signal B et que la fréquence du TCXO B est de 20MHz, alors il faut compter pendant une durée de $T = 2\ 10^7/20\ 10^6 = 1$ seconde.

Le comptage est réalisé par le compteur binaire 6 de capacité limitée. Le choix des paramètres (nombre d'évènements, taille du compteur 6, correction numérique du résultat) est tel que le résultat de ce comptage (binaire signé) est nul si les signaux SA et $S_B$ sont parfaitement synchrones. La taille du compteur 6 est déterminée en fonction de l'erreur maximale pouvant se produire entre le signal $S_A$ et le signal $S_B$. L'erreur maximale Emax est égale à la somme des erreurs maximales de chacun des oscillateurs A et B, en fonction de la température, du vieillissement et des variations de tension d'alimentation ; comme le compteur est binaire, on choisit la puissance de 2 immédiatement supérieure à l'erreur maximale calculée ci-dessus ; cette valeur est nommée M dans la suite du document.

Etape 3a : mise hors tension de l'oscillateur TCXO B. Le signal 4b correspond à l'enregistrement dans le bloc mémoire 5. La mémoire mémorise le nombre $N_B$ et aussi les ainsi que les nombres $N_{B-1}$, $N_{B-2}$, $N_{B-3}$,... $N_{B-n}$ mesurés précédemment,

Etape 4a: Le résultat du comptage $N_B$ obtenu pendant la durée T est comparé à celui des mesures précédentes. Une loi de variation polynomiale (de degré dépendant du nombre de valeurs précédentes enregistrées) est calculée par le bloc de calcul 8 (signal 4c), afin d'estimer la correction à appliquer à $N_B$, pour obtenir finalement l'erreur moyenne E valable pour la prochaine période du rythme $R_1$. Ce résultat E est mémorisé (signal 4d calcul et mémorisation de l'erreur E dans le bloc 7).

Simultanément à ces opérations exécutées à un rythme $R_1$, le séquenceur détermine un second rythme $R_2$ fixe dépendant de l'erreur maximale à corriger. La partie inférieure de la figure 2 schématise les étapes et opérations exécutées à ce deuxième rythme.

Etape 1 b : Le résultat précédent E est ajouté à l'accumulateur 9 au rythme $R_2$ (voir signal 4e figure 2).
Etape 2b : Lorsque la valeur de l'accumulateur 9, prise en valeur absolue, dépasse la valeur maximale prédéfinie M, alors le processeur 1 va exécuter les opérations suivantes :

- Modifier le rang de division K en K+1 ou K-1 selon le signe de la valeur de l'erreur contenue dans l'accumulateur, pendant une période du signal de sortie Scorr
- Soustraire de, ou ajouter à, l'accumulateur la valeur maximale M pour annuler le dépassement, selon le signe de ce dernier. Ceci est équivalent à une remise à zéro : l'application de la correction (changement du rang de division) doit s'accompagner du déchargement de l'accumulateur de l'équivalent de cette correction.

Le rythme $R_2$ (que l'on exprimera en durée en secondes) est déterminé à partir de l'erreur maximale admissible, qui est égale en valeur absolue à M, exprimé en nombre d'évènements de comptage du TCXO B pendant la durée T., et de l'amplitude de la correction temporelle appliquée à chaque dépassement de l'accumulateur, qui dépend de la fréquence de l'oscillateur A. En effet le changement de rang de division sur une période du signal Scorr (de fréquence moyenne $F_A$) modifie la durée de la période Scorr de plus ou moins une période du signal de l'oscillateur A.

Un exemple est donné pour illustrer les différentes opérations et étapes précitées.

Exemple : $F_A$ = 32768Hz, $F_B$ = 20MHz, comptage des périodes pendant T = 1 seconde, erreur maximale des oscillateurs = 200 ppm ou $2 \times 10^{-4}$ ; la valeur de M doit être supérieure à $20 \times 10^6 \times 2 \times 10^{-4} = 4000$, soit en pratique 4096 pour prendre une puissance de 2 entière ; l'erreur relative maximale admissible du dispositif est donc de $4096 / 20 \times 10^6 = 2.048 \times 10^{-4}$ ; cette erreur relative produit une erreur temporelle maximale à chaque période $R_2$, de $R_2 \times 2.048 \times 10^{-4}$ , erreur qui doit être égale à la capacité de correction calculée ci-dessus, de 1 période du signal A : $R_2 \times 2.048 \times 10^{-4} = 1 / F_A$ , ce qui permet de calculer $R_2 = 1/ (32768 \times 2.048 \times 10^{-4}) = 0.149$ s.

Un exemple est donné pour mieux comprendre la signification de la valeur de $R_1$ dans le cas d'une prédiction linéaire.

Détermination du rythme $R_1$ (exprimé en durée en secondes)

Exemple : correction prédictive linéaire (une seule valeur précédente mémorisée) ; pente de variation de fréquence maximale en fonction de la température = 5 ppm/°C ; pente de variation de la température en fonction du temps = 3°C/mn ; erreur maximale temporelle admissible lors du démarrage de cette variation de température $\Delta t = 180\mu s$ (soit 0.1 ppm sur 30mn). La pente fréquence/temps P est de 5 ppm/°C x 3°C/mn = 15 ppm/mn ou $2.5 \times 10^{-7}$/s.

La correction prédictive ne peut éviter une erreur lors du démarrage de la variation de fréquence. On peut avoir dans le cas le plus défavorable (démarrage de la variation juste après une mesure de fréquence), une erreur de fréquence croissante pendant toute une période $R_1$. On montre que la dérive temporelle $\Delta t$ correspondante en fin de période $R_1$ est égale à $(R_1)^2 \times P / 2$ . Durant la période $R_1$ suivante, l'erreur temporelle est compensée exactement par la correction prédictive (on connait 2 valeurs successives de la fréquence qui permettent de déterminer la pente P et de la corriger).

Dans le cas indiqué, la valeur de $R_1$ maximale vaut donc :

$$R_1 \geq \sqrt{(2 \Delta t / P)} = \sqrt{(2 \times 180 \cdot 10^{-6} / 2.5 \cdot 10^{-7})} = 37.9 \text{ s}$$

Le système selon l'invention présente notamment comme avantage de fournir un oscillateur basse fréquence ayant une précision élevée de l'ordre de quelques ppm et une faible consommation d'environ 10 fois inférieure à celle d'un oscillateur TCXO classique.

Cette faible consommation est assurée par l'emploi d'un oscillateur à quartz basse fréquence permanent.

La stabilité en température est assurée par l'emploi d'un TCXO de calibration et la stabilité pendant les variations de température est obtenue au moyen d'un algorithme prédictif mis en oeuvre dans le processeur précité et ses composants.

La génération d'un signal sans ruptures de phase est assurée par l'absence de commutations entre 2 oscillateurs. Les appels de consommation sont réduits par l'emploi d'une capacité réservoir. Un faible coût est assuré par l'absence de calibration en température et l'emploi de composants courants.

**Revendications**

1. Oscillateur basse fréquence de précision et de faible consommation **caractérisé en ce qu'**il comporte en combinaison au moins les éléments suivants :

   • Un oscillateur basse fréquence A de faible consommation, adapté à fonctionner à une fréquence $F_A$, et émettre un signal $S_A$,
   • Un oscillateur à quartz compensé en température TCXO B utilisé comme référence fréquentielle, adapté à fonctionner à une fréquence $F_B$,
   • Un circuit numérique (1) adapté à fournir une fréquence Fcor stable comprenant au moins :

   ○ Une entrée (1a) pour recevoir un signal d'alimentation,
   ○ Une entrée (1b) pour recevoir en permanence un signal SA issu de l'oscillateur A,
   ○ Une entrée (1 c) pour recevoir le signal $S_B$ issu de l'oscillateur B pendant la calibration, réalisée à un rythme $R_1$, lorsqu'un commutateur (3) est activé par un séquenceur (4) gérant l'ensemble des composants formant le circuit,
   ○ Un compteur (6) adapté à compter le nombre d'impulsions émises par l'oscillateur B pendant une période donnée, de façon à représenter l'erreur entre les oscillateurs A et B,
   ○ Une mémoire (5) mémorisant le nombre $N_B$ issu du compteur (6), ainsi que les nombres $N_{B-1}$, $N_{B-2}$, $N_{B-3}$,... $N_{B-n}$ d'impulsions émises par l'oscillateur B et comptées par le compteur (6) pendant des périodes précédentes,
   ○ Un module (8) de calcul de correction permettant d'analyser les résultats du comptage $N_B$ à un moment donné et ceux des comptages $N_{B-n}$ précédemment enregistrés, et d'en déduire une correction à appliquer au comptage $N_B$,
   ○ Un additionneur (7) recevoir les valeurs issues du compteur
   et du module de calcul de correction, et à délivrer à sa sortie un nombre représentant une erreur corrigée E qui est mémorisée,
   ○ Un accumulateur (9) dans lequel on additionne ladite erreur corrigée à un rythme $R_2$, comprenant une valeur seuil prédéfinie M ; lorsque la valeur de l'accumulateur (9), prise en valeur absolue, dépasse ladite valeur seuil prédéfinie M, ledit accumulateur (9) est adapté à délivrer à un diviseur de rang variable (10), d'une part un indicateur de dépassement et d'autre part le signe de ce dépassement ; dans ce cas de dépassement, on soustrait de, ou ajoute à, l'accumulateur (9) ladite valeur seuil prédéfinie M pour annuler le dépassement,
   ○ Le diviseur de rang variable (10) ayant une valeur nominale K ; en cas de dépassement de la valeur de l'accumulateur (9), le rang de division K est modifié en K+1 ou K-1 est selon le signe de la valeur de l'erreur contenue dans l'accumulateur, pendant une période du signal de sortie Scorr, ledit diviseur à rang variable est adapté à produire signal souhaité et corrigé Scorr.

2. Oscillateur selon la revendication 1 **caractérisé en ce que** l'oscillateur A est un oscillateur fonctionner à une fréquence $F_A$ dont la valeur est choisie afin que ledit oscillateur ait une faible consommation, une précision et une stabilité en température maîtrisées.

3. Oscillateur selon la revendication 2 **caractérisé en ce que** la valeur de la fréquence $F_A$ est égale à 32768 Hz.

4. Oscillateur selon l'une des revendications 1 ou 3 **caractérisé en ce que** l'oscillateur TCXO B est un oscillateur adapté à fonctionner à une fréquence $F_B$ choisie dans l'intervalle compris entre 10 et 30MHz.

5. Oscillateur selon l'une des revendications 1 à 4 **caractérisé en ce que** le circuit est un composant fabriqué en technologie CMOS ou toute autre technologie à faible consommation sous forme d'un ASIC, d'un CPLD, d'un FPGA ou de microprocesseur.

6. Oscillateur selon l'une des revendications 1 à 5 **caractérisé en ce qu'**il comporte un régulateur (2) disposé sur la tension d'alimentation et un circuit composé d'une résistance R et d'une capacité réservoir C situé entre l'alimentation et le régulateur (2).

7. Utilisation d'un oscillateur selon l'une des revendications 1 à 6 pour des radiocommunications.

8. Procédé pour délivrer un signal Scorr de fréquence stable à partir d'un oscillateur basse fréquence de précision et de faible consommation selon la revendication 1, **caractérisé en ce qu'**il comporte en combinaison au moins les étapes suivantes :

Déterminer un premier rythme $R_1$ fixe pour mesurer périodiquement l'erreur de fréquence de l'oscillateur A,

Etape 1a : mettre sous tension un oscillateur à quartz compensé en température TCXO B et attendre sa stabilisation,

Etape 2a : compter dans un compteur (6) des périodes ou transitions du signal $S_B$, émis par l'oscillateur B nombre d'impulsions émises pendant une durée T ou durée de comptage définie à partir de la période du signal SA,

Etape 3a : mettre hors tension l'oscillateur à quartz compensé en température TCXO B, mémoriser le nombre $N_B$ correspondant au comptage de l'étape 2a, et mettre à jour les nombres $N_{B-1}$, $N_{B-2}$, $N_{B-3}$,... $N_{B-n}$ d'impulsions émises par l'oscillateur B pendant les périodes précédentes et comptées par compteur (6) ,

Etape 4a: comparer le résultat du comptage $N_B$ obtenu pendant la durée T à celui des mesures précédentes $N_{B-1}$, $N_{B-2}$, $N_{B-3}$,... $N_{B-n}$, déterminer une loi de variation polynomiale afin d'estimer la correction à appliquer à $N_B$, pour obtenir finalement une erreur moyenne E probable pour la prochaine période du rythme $R_1$ et mémoriser cette valeur E,

Déterminer un deuxième rythme $R_2$ et exécuter les étapes suivantes :

Etape 1b : ajouter l'erreur moyenne mémorisée E à un accumulateur au rythme $R_2$,

Etape 2b : Lorsque la valeur de l'accumulateur (9), prise en valeur absolue, dépasse une valeur maximale prédéfinie M, alors transmettre à un diviseur de rang variable (10), ayant une valeur nominale K d'une part un indicateur de dépassement et d'autre part le signe de ce dépassement et exécuter les opérations suivantes :

- Modifier le rang de division K en K+1 ou K-1 selon le signe de la valeur de l'erreur contenue dans l'accumulateur, pendant une période du signal de sortie Scorr.
- Soustraire de, ou ajouter à, l'accumulateur la valeur seuil prédéfinie M pour annuler le dépassement.

9. Procédé selon la revendication 8 **caractérisé en ce que** l'on détermine le rythme $R_2$ à partir de l'erreur maximale admissible égale en valeur absolue à la valeur seuil prédéfinie de l'accumulateur M et de l'amplitude de la correction temporelle appliquée à chaque dépassement de l'accumulateur.

**Claims**

1. A high-precision low-frequency oscillator with low consumption, **characterised in that** it comprises in combination at least the following elements:

    - a low consumption, low-frequency oscillator A, adapted to operate at a frequency $F_A$, and adapted to emit a signal $S_A$,
    - a temperature compensated quartzoscillator TCXO B used as a frequency reference, adaptedto operate at a frequency $F_B$,
    - a digital circuit (1) adapted to provide a stable frequency $F_{COR}$, which comprises at least:

        - an input (1a) for receiving a supply signal,
        - an input (1b) for continuously receiving a signal $S_A$ originating from said oscillator A,
        - an input (1c) for receiving the signal $S_B$ originating from said oscillator B during calibration performed at a rate $R_1$, when a switch (3) is activated by a sequencer (4) that manages all of the components that form the circuit,
        - a counter (6) adapted to count the number of pulses emitted by said oscillator B during a given period so as to represent the error between said oscillators A and B,
        - a memory (5) recording the number $N_B$ originating from said counter (6) as well as the numbers $N_{B-1}$, $N_{B-2}$, $N_{B-3}$, ...$N_{B-n}$ of pulses that are emitted by said oscillator B and that are counted by said counter (6) during the preceding periods,
        - a module (8) for calculating a correction that allows the results of the count $N_B$, at a given moment, as well as those of the previously recorded counts $N_{B-n}$ to be analysed, and a correction to be applied to the count $N_B$ to be deduced therefrom,

- an adder (7) designed to receive the values originating from said counter and the correction calculation module and to deliver to its output a number representing a corrected error E that is recorded,

- an accumulator (9) in which said corrected error is added at a rate $R_2$, said accumulator comprising a predefined threshold value M; when the value of said accumulator (9), taken as an absolute value, exceeds said predefined threshold value M, said accumulator (9) is designed to deliver an excess indicator on the one hand and the sign of this excess on the other hand to a variable row splitter (10); wherein in the case of an excess, said predefined threshold value M is subtracted or added to the accumulator (9) in order to cancel the excess,

- the variable row splitter (10) having a nominal value K; in case the value of said accumulator (9) is exceeded, the row of division K is changed to K+1 or K-1 depending on the sign of the value of the error contained in said accumulator, for a period of the output signal Scorr, said variable row splitter is designed to produce the desired and corrected signal Scorr.

2. The oscillator according to claim 1, **characterised in that** said oscillator A is an oscillator adapted to operate at a frequency $F_A$, the value of which is selected so that said oscillator has a low consumption, a high-precision and stability at a controlled temperature.

3. The oscillator according to claim 2, **characterised in that** the value of the frequency $F_A$ is equal to 32,768 Hz.

4. The oscillator according to claim 1 or 3, **characterised in that** said oscillator TCXO B is an oscillator that is adapted to operate at a frequency $F_B$ that is selected in an interval between 10 and 30MHz.

5. The oscillator according to any one of claims 1 to 4, **characterised in that** the circuit is a component manufactured using CMOS technology or any other low consumption technology in the form of an ASIC, a CPLD, an FPGA or a microprocessor.

6. The oscillator according to any one of claims 1 to 5, **characterised in that** it comprises a regulator (2) that is disposed on the voltage supply and a circuit composed of a resistor R and a reservoir capacitor C that is located between the supply and the regulator (2).

7. The use of an oscillator, according to any one of claims 1 to 6, for radio communications.

8. A method for providing a stable frequency signal Scorr from a high-precision low frequency oscillator with low consumption according to claim 1, **characterised in that** it comprises in combination at least the following steps:

determining a first fixed rate $R_1$ for periodically measuring the frequency error of said oscillator A,

Step 1a: powering-on a temperature compensated quartzoscillator TCXO B and waiting for it to stabilise,
Step 2a: counting, using a counter (6), the periods or transitions of the signal $S_B$ emitted by said oscillator B (number of emitted pulses) for a duration T or counting duration that is defined on the basis of the period of the signal $S_A$,
Step 3a: powering-off the temperature compensated quartz oscillator TCXO B, recording the number $N_B$ that corresponds to the count of step 2a, and updating the numbers $N_{B-1}$, $N_{B-2}$, $N_{B-3}$, ...$N_{B-n}$ of pulses emitted by said oscillator B during the preceding periods and that are counted by said counter (6),
Step 4a: comparing the result of the count $N_B$ obtained during the duration T with that of the preceding measurements $N_{B-1}$, $N_{B-2}$, $N_{B-3}$, ...$N_{B-n}$, determining a polynomial variation rule so as to estimate the correction to be applied to $N_B$ in order to finally obtain a probable mean error E for the next period of the rate $R_1$ and recording this value E,

determining a second rate $R_2$ and performing the following steps:

Step 1b: adding the recorded mean error E to an accumulator at the rate $R_2$,
Step 2b: sending an excess indicator on the one hand and the sign of this excess on the other hand to a variable row splitter (10) that has a nominal value K when the value of said accumulator (9), taken as an absolute value, exceeds a maximum predefined value M and performing the following operations:

- changing division row K to K+1 or K-1 depending on the sign of the value of the error contained in said accumulator for a period of the output signal Scorr,
- subtracting from, or adding to, said accumulator the predefined threshold value M so as to cancel the excess.

**9.** The method according to claim 8, **characterised in that** the rate $R_2$ is determined on the basis of the maximum permissible error that is equal by absolute value to the predefined threshold value M of said accumulator and of the amplitude of the temporal correction applied to each excess of said accumulator.

**Patentansprüche**

**1.** Präziser Niederfrequenzoszillator mit geringem Verbrauch, **dadurch gekennzeichnet, dass** er in Kombination wenigstens die folgenden Elemente umfasst:

- einen verbrauchsarmen Niederfrequenzoszillator A zum Arbeiten bei einer Frequenz $F_A$ und zum Emittieren eines Signals $S_A$,
- einen temperaturkompensierten Quarzoszillator TCXO B, der als Frequenzreferenz verwendet wird, zum Arbeiten auf einer Frequenz FB,
- eine Digitalschaltung (1) zum Erzeugen einer stabilen Frequenz $F_{COR}$, die wenigstens Folgendes umfasst:

  - einen Eingang (1a) zum Empfangen eines Versorgungssignals,
  - einen Eingang (1b) zum permanenten Empfangen eines vom Oszillator A stammenden Signals $S_A$,
  - einen Eingang (1c) zum Empfangen des vom Oszillator B stammenden Signals $S_B$ während der Kalibrierung, die mit einer Rate $R_1$ durchgeführt wird, wenn ein Schalter (3) von einem Folgeschalter (4) aktiviert wird, der alle die Schaltung bildenden Komponenten verwaltet,
  - einen Zähler (6) zum Zählen der vom Oszillator B während einer gegebenen Periode emittierten Impulse, um den Fehler zwischen den Oszillatoren A und B darzustellen,
  - einen Speicher (5) zum Speichern der vom Zähler (6) kommenden Zahl $N_B$ sowie der Zahlen $N_{B-1}$, $N_{B-2}$, $N_{B-3}$, ...$N_{B-n}$ von Impulsen, die vom Oszillator B emittiert und vom Zähler (6) während der vorhergehenden Perioden gezählt werden,
  - ein Modul (8) zum Berechnen der Korrektur, die eine Analyse der Zählergebnisse $N_B$ in einem gegebenen Moment sowie der zuvor gespeicherten Zählergebnisse $N_{B-n}$ und eine Ableitung einer auf die Zahl $N_B$ anzuwendenden Korrektur davon zulässt,
  - einen Addierer (7) zum Empfangen der von dem Zähler und dem Korrekturrechenmodul stammenden Werte und zum Anlegen einer einen korrigierten Fehler E repräsentierenden Zahl an seinen Ausgang, die gespeichert wird,
  - einen Akkumulator (9), in dem der korrigierte Fehler mit einer Rate $R_2$ addiert wird, die einen vordefinierten Schwellenwert M umfasst; wobei, wenn der Wert des Akkumulators (9), als absoluter Wert genommen, den vordefinierten Schwellenwert M übersteigt, der Akkumulator (9) einen Überschreitungsindikator einerseits und das Vorzeichen dieser Überschreitung andererseits einem variablen Reihenteiler (10) zuführt; wobei in diesem Überschreitungsfall der vordefinierte Schwellenwert M vom Akkumulator (9) subtrahiert oder zu diesem addiert wird, um die Überschreitung zu löschen,
  - den variablen Reihenteiler (10) mit einem Nennwert K; wobei in dem Fall, dass der Wert des Akkumulators (9) überschritten wird, die Teilungsreihe K je nach dem Vorzeichen des im Akkumulator enthaltenen Fehlerwertes auf K+1 oder K-1 für eine Periode des Ausgangssignals Scorr geändert wird, wobei der variable Reihenteiler zum Erzeugen des gewünschten und korrigierten Signals Scorr ausgelegt ist.

**2.** Oszillator nach Anspruch 1, **dadurch gekennzeichnet, dass** der Oszillator A zum Arbeiten auf einer Frequenz $F_A$ ausgelegt ist, deren Wert so gewählt wird, dass der Oszillator einen geringen Verbrauch, eine hohe Präzision und Stabilität bei einer geregelten Temperatur hat.

**3.** Oszillator nach Anspruch 2, **dadurch gekennzeichnet, dass** der Wert der Frequenz $F_A$ gleich 32.768 Hz ist.

**4.** Oszillator nach Anspruch 1 oder 3, **dadurch gekennzeichnet, dass** der Oszillator TCXO B ein Oszillator ist, der zum Arbeiten auf einer Frequenz $F_B$ ausgelegt ist, die in einem Intervall zwischen 10 und 30MHz gewählt wird.

**5.** Oszillator nach einem der Ansprüche 1 bis 4, **dadurch gekennzeichnet, dass** die Schaltung eine Komponente ist, die mit CMOS-Technik oder einer anderen verbrauchsarmen Technik in Form einer ASIC, eines CPLD, einer FPGA oder eines Mikroprozessors vorliegt.

6. Oszillator nach einem der Ansprüche 1 bis 5, **dadurch gekennzeichnet, dass** er einen Regler (2) umfasst, der auf der Spannungsversorgung angeordnet ist, und eine Schaltung umfasst, die aus einem Widerstand R und einem Reservoirkondensator C besteht, der sich zwischen der Versorgung und dem Regler (2) befindet.

7. Verwendung eines Oszillators nach einem der Ansprüche 1 bis 6 für Funkkommunikationen.

8. Verfahren zum Erzeugen eines Signals Scorr mit stabiler Frequenz von einem präzisen Niederfrequenzoszillator mit geringem Verbrauch nach Anspruch 1, **dadurch gekennzeichnet, dass** es in Kombination wenigstens die folgenden Schritte beinhaltet:

Ermitteln einer ersten festen Rate $R_1$ zum periodischen Messen des Frequenzfehlers des Oszillators A,

Schritt 1a: Einschalten eines temperaturkompensierten Quarzoszillators TCXO B und Warten, bis er sich stabilisiert hat,
Schritt 2a: Zählen, mit einem Zähler (6), der Perioden oder Übergänge des Signals $S_B$, das von dem Oszillator B ausgegeben wurde (Zahl der emittierten Impulse) für eine Dauer T oder Zähldauer, die auf der Basis der Periode des Signals $S_A$ definiert wird,
Schritt 3a: Abschalten des temperaturkompensierten Quarzoszillators TCXO B, Speichern der Zahl $N_B$, die der Zählung von Schritt 2a entspricht, und Aktualisieren der Zahlen $N_{B-1}$, $N_{B-2}$, $N_{B-3}$, ...$N_{B-n}$ von Impulsen, die vom Oszillator B während der vorherigen Perioden emittiert und vom Zähler (6) gezählt wurden,
Schritt 4a: Vergleichen des Ergebnisses der Zählung von $N_B$ während der Dauer T mit dem der vorherigen Messungen $N_{B-1}$, $N_{B-2}$, $N_{B-3}$, ...$N_{B-n}$, Ermitteln einer Polynom-Variationsregel, um die auf $N_B$ anzuwendende Korrektur zu schätzen, um schließlich einen wahrscheinlichen durchschnittlichen Fehler E für die nächste Periode der Rate $R_1$ zu erhalten, und Speichern dieses Wertes E,

Ermitteln einer zweiten Rate $R_2$ und Ausführen der folgenden Schritte:

Schritt 1b: Addieren des gespeicherten durchschnittlichen Fehlers E zu einem Akkumulator mit der Rate $R_2$,
Schritt 2b: Senden eines Überschreitungsindikators einerseits und des Vorzeichens dieser Überschreitung andererseits an einen variablen Reihenteiler (10) mit einem Nennwert K, wenn der Wert des Akkumulators (9), als absoluter Wert genommen, einen maximalen vordefinierten Wert M übersteigt, und Ausführen der folgenden Operationen:

- Ändern der Teilungsreihe K auf K+1 oder K-1 je nach dem Vorzeichen des Wertes des Fehlers, der im Akkumulator enthalten ist, für eine Periode des Ausgangssignals Scorr,
- Subtrahieren oder Addieren des vordefinierten Schwellenwertes M von/zu dem Akkumulator, um die Überschreitung zu löschen.

9. Verfahren nach Anspruch 8, **dadurch gekennzeichnet, dass** die Rate $R_2$ auf der Basis des maximal zulässigen Fehlers ermittelt wird, der nach absolutem Wert gleich dem vordefinierten Schwellenwert des Akkumulators M und der Amplitude der zeitlichen Korrektur ist, die auf jede Überschreitung des Akkumulators angewendet wird.

FIG.1

FIG.2

Signal SWB

Temps de démarrage
du TCXO

Signal SA (TCXO B)

T (durée de comptage)

Signal 4a
(autorisation du
comptage dans le bloc 6)

Signal 4b
(enregistrement dans le
bloc mémoire 5)

Signal 4c
(calcul de la correction
prédictive dans le bloc 8)

Signal 4d
(calcul et mémorisation de
l'erreur E dans le bloc 7)

FIG.3

EP 2 319 180 B1

**EP 2 319 180 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1585223 A